# EUROPEAN PATENT APPLICATION

(11) **EP 4 753 151 A1**
(43) Date of publication of application: **03.06.2026**
(21) Application number: 25212982.0
(22) Date of filing: 03.11.2025
(51) Int. Cl.: H03M 1/12

(54) **RAPID BURST MODE SERDES TUNING**

(30) Priority: 27.11.2024 US 202418961859
(71) Applicant: Avago Technologies International Sales Pte. Limited, Singapore 768923 (SG)
(72) Inventor: Hirth, Ryan Edgar, Windsor, CA, 95492 (US); Dvir, Amiad, Aliso Viejo, CA, 92656 (US)
(74) Representative: Grünecker Patent- und Rechtsanwälte PartG mbB

(57) **Abstract**

A terminal including a transceiver, an analog-to-digital converter and control circuitry. The transceiver receives a stream of bursts from a plurality of units. One of the units is an electronic device. The analog-to-digital converter receives an upstream burst from the transceiver during an active time slot. The upstream burst is one of the bursts. In response to sampling the upstream burst at a sample rate, the analog-to-digital converter converts the upstream burst from an analog waveform into a sequence of digital values. In response to a coefficient for the electronic device being a default coefficient, the control circuitry stores the digital values into memory during the active time slot.

## Description

### BACKGROUND

A SerDes (Serializer/Deserializer) is an electronic device used in high-speed communication systems to convert parallel data into serial data for transmission and convert the serial data into the parallel data upon reception. The deserializer part of the SerDes receives a high-speed serial data stream from a data channel for conversion into parallel data channel whereas the serializer part of the SerDes converts parallel data into a serial data stream for transmission over the data channel.

### BRIEF DESCRIPTION OF DRAWINGS

The accompanying drawings, which are incorporated in and form a part of this specification, illustrate examples of the disclosure and, together with the description, explain principles of the examples.
FIG. 1 illustrates a functional block diagram of an exemplary network, in accordance with one or more embodiments of the disclosure.
FIG. 2 illustrates a functional block diagram of an exemplary deserializer, in accordance with one or more embodiments of the disclosure.

In the drawings, like reference symbols and numerals indicate the same or similar components. Like elements in the various figures are denoted by like reference symbols and numerals for consistency. Unless otherwise indicated, like elements and method steps are referred to with like reference numerals.

### DETAILED DESCRIPTION OF THE INVENTION

The following describes technical solutions in this specification with reference to the accompanying drawings. Exemplary embodiments are described in detail with reference to the accompanying drawings.

The terminology used herein is for describing various examples only, and is not to be used to limit the disclosure. Unless otherwise defined, all terms, including technical and scientific terms, used herein have the same meaning as commonly understood by one of ordinary skill in the art to which this disclosure pertains and after an understanding of the disclosure of this application.

Terms, such as those defined in commonly used dictionaries, are to be interpreted as having a meaning that is consistent with their meaning in the context of the relevant art and the disclosure of this application. Although the present technology has been described by referring to certain examples, workers skilled in the art will recognize that changes may be made in form and detail without departing from the scope of the discussion.

A typical Optical Line Terminal Passive Optical Network SerDes (OLT PON SerDes) is a specialized Serializer/Deserializer used in optical networks to handle high-speed data transmission between the Optical Line Terminal (OLT) and multiple Optical Network Units (ONUs) over the Passive Optical Network (PON). The OLT PON SerDes efficiently converts parallel data streams from the OLT into serial format for transmission and then converts incoming serial data back into parallel format, supporting high-bandwidth, multi-user communication in fiber-optic networks.

In a PON network, new ONU devices must be discovered and registered at the OLT. The OLT opens a ranging window where the new ONU may send a message. The OLT needs to receive this message to add the ONU to the network. The message send upstream is relatively short in terms of the time it takes to train a typical Serializer/Deserializer equalizer. Since the ONU is operating in a soft decision mode, there is a wide range of incoming signals to which the ONU must adapt. Accordingly, there is a need in the art for an improved Serializer/Deserializer.

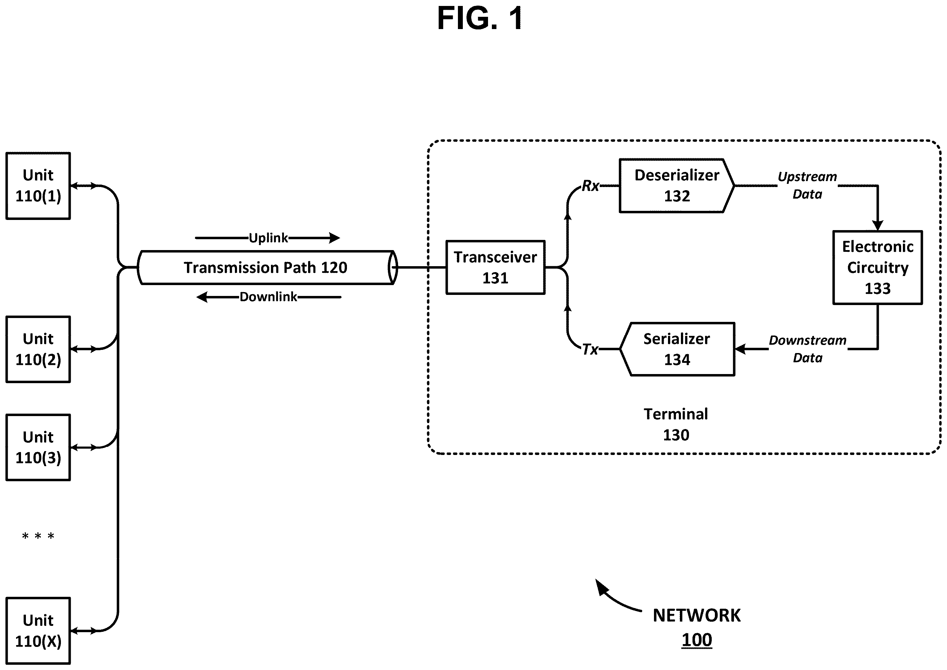

Referring to FIG. 1, network 100 is illustrated. Network 100 may be a data network that allows for the distribution of information. The network 100 may include a public or private data network. The public or private data network may comprise or be part of a data bus, a wired or wireless network, a public switched telephone network, a satellite network, a local area network (LAN), a wide area network (WAN), and/or the Internet. Included in network 100 are units 110(1) - 110(X), with "X" being an integer number greater than 1. Units 110(1) - 110(X) may be collectively referred to as "units 110." Any one of the units 110(1) - 110(X) may be individually referred to as "unit 110." For simplicity and ease of understanding, the FIG. 1 shows a case in which four units 110 are present. However, network 100 may accommodate more than four units 110, if not thousands or more units 110. The total amount of units 110 in the network 100 may vary depending on the number of units 110 that are connected to network 100. Each unit 110 may be individually identifiable by a unique Media Access Control (MAC) address. A MAC address for any unit 110 differs from the MAC address for any other unit 110. In some instances, a unit 110 may be individually identifiable by a unique IP address. The respective IP address for any of the units 110 may differ from the IP address for any other units 110 in network 100.

Unit 110 may be an electronic device. By way of illustration, unit 110 may be any type of electrically-powered device having computing capability. For example unit 110 may be a computer terminal, a laptop computer, a tablet computer, and/or any other computing device. In some examples, unit 110 may be telephone, a mobile phone, a smart phone, a cell phone and/or any other electronic telecommunications device. In other examples, unit 110 may be a television set, a video device such as a video display, a video recorder, a digital video recorder (DVR), a set-top box, a set-back box and/or any other electronic entertainment device.

Unit 110 may be a sensor, a power-over-ethernet device, a printer, an appliance (e.g., a washer, dryer, refrigerator, oven and/or other appliance), an internet of things (IOT) device and/or any other electronic device that is capable of electrically communicating with the network 100.

Unit 110 may be any portable electronic device that can be carried by or worn on a person. For example, unit 110 may be configured as a wearable device, a smartwatch, a fitness tracker or a personal digital assistant (PDA).

In some examples, unit 110 may be found in apparatuses such as autonomous vehicles, robots and drones. Unit 110 may be configured as a driver assistance module in a vehicle, a computing device for a vehicle and/or entertainment device for a vehicle. Unit 110 may include a network interface card, a router, a server, a hub, a network switch, a modem, a bridge, an access point, a gateway, and/or mesh network interface. Unit 110 may be found in an artificial intelligence (AI) network.

Unit 110 may be any electronic circuitry capable of providing an input signal to terminal 130. For example, unit 110 may be a photodiode, a photomultiplier tube, an ultrasound transducer, and/or a radiation detector. In some implementations, unit 110 may be a capacitive sensor, a temperature sensor, an electrochemical sensor, a biosensor, and/or a magnetic field sensor. In other examples, unit 110 may be an ethernet device, an optical receiver, an optical transceiver, a fiber-optic receiver, a fiber-optic transceiver, an infrared (IR) receiver, an IR transceiver, a radio frequency (RF) receiver, an RF transceiver, a microwave receiver, a microwave transceiver, an ultrasound receiver, an ultrasound transceiver, a cellular receiver, a cellular transceiver, a global positioning system (GPS) receiver, a GPS transceiver, a satellite communication receiver, a satellite communication transceiver, a television signal receiver, a Wi-Fi receiver, a Wi-Fi transceiver, an audio receiver and/or an audio transceiver. In some implementations, unit 110 may be an optical network unit. The list above is not intended to be exhaustive.

Also included in network 100 are transmission path 120 and terminal 130. Those skilled in the art will appreciate that there may be additional infrastructure in network 100 that is not shown in FIG. 1. The network 100 may facilitate the transfer of information serially between terminal 130 and units 110 via transmission path 120.

Implemented as a bidirectional data link, transmission path 120 may allow information to flow in both directions between terminal 130 and units 110 to facilitate two-way communication between units 110 and terminal 130. Transmission path 120 may include, but is not limited to, a serial transmission path such as a Passive Optical Network (PON), Ethernet, Universal Serial Bus (USB), Peripheral Component Interconnect (PCI) Express, Serial Advanced Technology Attachment (SATA), an optical fiber, a fiber optic cable, Fiber Channel, High-Definition Multimedia Interface (HDMI), DisplayPort, Thunderbolt, Serial Digital Interface (SDI), Serial Attached SCSI (SAS), Synchronous Optical Network / Synchronous Digital Hierarchy (SONET/SDH), InfiniBand, RS-232, RS-485, Mobile Industry Processor Interface (MIPI), Controller Area Network (CAN) Bus, Inter-Integrated Circuit (I2C), Serial Peripheral Interface (SPI), Bluetooth, Zigbee, Long Range (LoRa) and/or any other serial transmission path.

Terminal 130 is an apparatus that may output downstream information Tx onto transmission path 120 and receive upstream bursts Rx from transmission path 120. In some instances, terminal 130 may happen to be an optical line terminal in a passive optical network. Terminal 130 may include transceiver 131, deserializer 132, electronic circuitry 133 and serializer 134. Those skilled in the art will appreciate that there may be additional components in terminal 130 that are not shown in FIG. 1.

Transceiver 131 is a device that may both transmit downstream information Tx to any unit 110 and receive upstream bursts Rx from any unit, converting signals between different forms (such as electrical to optical). Transceiver 131 may establish duplex communication with each of the units 110 either simultaneously (full-duplex) or alternately (half-duplex). This duplex communication may include two communication channels. For transceiver 131 to achieve electronic separation of the communication channels from one another, the frequency for the downstream information Tx may differ from the frequency for the upstream bursts Rx.

One of the communication channels is a downlink for outbound transmission of downstream information Tx by transceiver 131 to any of the units 110. Serializer 134 is circuitry that may convert downstream data, which is parallel data from electronic circuitry 133, into bursts of downstream information Tx for transmission over the downlink in transmission path 120. The downstream information Tx may exist in a serialized format allowing for transmission over the downlink, which is a single channel.

Another of the communication channels is an uplink for inbound reception of upstream bursts Rx from any of the units 110 to transceiver 131. In some implementations, burst mode transmission is adopted for the uplink, as will be explained in detail. Units 111 may share the uplink in as a result of time division multiple access (TDMA) multiplexing. By this approach, transceiver 131 may receive a stream of bursts from a plurality of units 110. Referred to herein, a "stream of bursts" is a sequence of data packets transmitted during designated time slots or on-demand. Each of the bursts may include multiple packets of information. Transceiver 131 may receive the stream of bursts from a transmission path 120 in real time. The coding scheme between transceiver 131 and any of the units 110 may be non-return-to-zero (NRZ), pulse amplitude modulation with 4 levels (PAM4) and/or any other coding scheme.

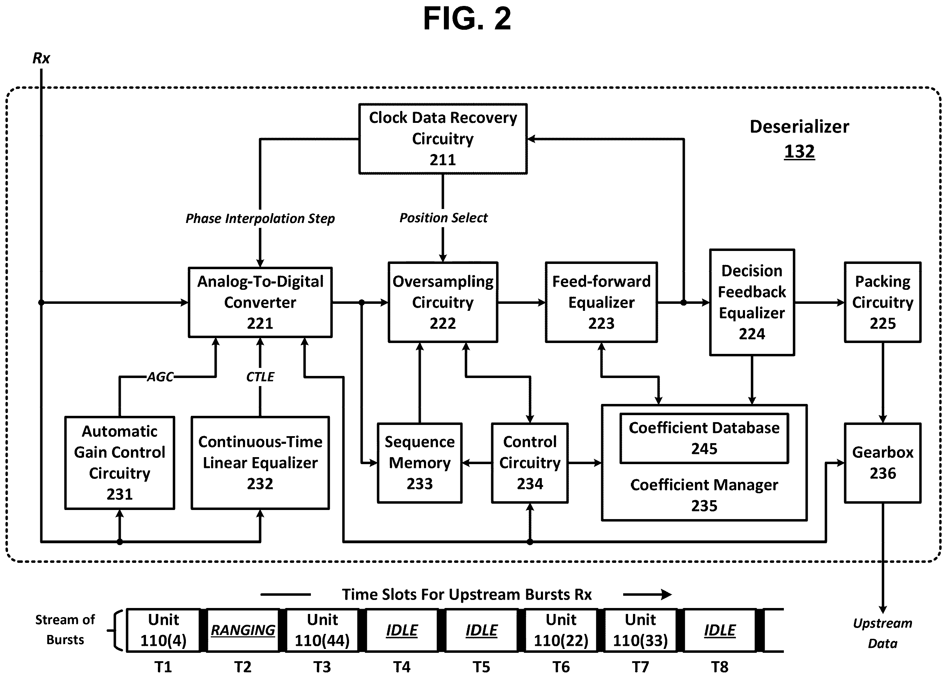

Referring to FIG. 2, deserializer 132 is illustrated. Deserializer 132 is circuitry that may convert the packets of the information received in the upstream bursts Rx from transmission path 120 into upstream data. Upstream data may exist as parallel data bits. The information contained in each packet of an upstream burst Rx may be serialized data (data sent sequentially over the uplink). Electronic circuitry 133 may process and manipulate of the upstream data.

Transceiver 131 may receive a stream of bursts from transmission path 120 in real time. A given unit 110 may transmit bursts of packets to transceiver 131 only during a time designated time slots that terminal 130 allocates for use by the given unit 110. In some instances, a time slot may be of a same time duration as another time slot. In other instances, the time durations of the time slot and the other time slot may differ from one another. Illustrating by example for simplicity and ease of understanding, an exemplary stream of bursts in FIG. 2 shows time slots T1-T8. It should be noted that transceiver 131 may continuously and constantly receive bursts during successive time slots.

Referred to herein, an "active time slot" is a time period within which transceiver 131 receives any one of the bursts in the stream. For example, transceiver 131 may receive a burst for unit 110(4) in an active time slot T1 and a burst for unit 110(44) in an active time slot T3 in the example of FIG. 2. Also in the example of FIG. 2, transceiver 131 may receive a burst for unit 110(22) in an active time slot T6 and a burst for unit 110(33) in an active time slot T7.

A ranging window may occur in time slot T2. Referred to herein, a "ranging window" is a time period within which terminal 130 may measure and equalize upstream bursts Rx from any unit 110 connected to terminal 130. Transceiver 131 may receive a ranging request from a unit 110. Any unit 110 transmitting a ranging request is a "ranging unit." A ranging request is a request made by unit 110 to establish timing synchronization with terminal 130. In response to transceiver 131 receiving a ranging request from ranging unit 110, control circuitry 234 may allocate a ranging window for ranging unit 110. For example, FIG. 2 may illustrate time slot T2 as a ranging window. During a ranging window, terminal 130 may perform ranging by measuring the round-trip time between transceiver 131 and unit 110 each connected to transmission path 120.

Referred to herein, an "idle time slot" is a time period within which transceiver 131 awaits a burst. For example, no burst exists in the idle time slots T4, T5 and T8. An idle time slot may happen to occur between an active time slot and another active time slot. Likewise, an active time slot may happen to occur between an idle time slot and another idle time slot.

Deserializer 132 may include clock data recovery circuitry 221, analog-to-digital converter 221, oversampling circuitry 222, feed-forward equalizer 223, decision feedback equalizer 224, packing circuitry 225, automatic gain control circuitry 231, continuous-time liner equalizer 232, sequence memory 233, control circuitry 234, coefficient manager 235 and gearbox 236. Those skilled in the art will appreciate that there may be additional components in deserializer 132 that are not shown in FIG. 2.

Transceiver 131 may receive a stream of bursts from a plurality of units 110. Analog-to-digital converter 221 may receive an upstream burst Rx from transceiver 131 during an active time slot. The upstream burst Rx, which is an analog waveform, is one of the bursts in the stream. Analog-to-digital converter 221 may sample the upstream burst Rx to convert the upstream burst from the analog waveform into a sequence of digital values. The sequence is a digital representation of the upstream burst Rx.

Analog-to-digital converter 221 may receive an automatic gain control (AGC) signal from automatic gain control circuitry 231. On such instances where analog-to-digital converter 221 transforms the upstream burst Rx into a sequence of digital values, analog-to-digital converter 221 may pre-condition the upstream burst Rx with the AGC signal prior to transforming the upstream burst Rx into the sequence of digital values. While pre-conditioning the upstream burst Rx with the AGC signal, analog-to-digital converter 221 may dynamically adjust the amplitude of the upstream burst Rx. Referred to herein, the "dynamic range" of analog-to-digital converter 221 is the range between the smallest and largest signal amplitude levels of an upstream burst Rx that analog-to-digital converter 221 can accurately represent. Dynamically adjusting the amplitude of the upstream burst Rx may ensure that the upstream burst Rx remains within the dynamic range of the analog-to-digital converter 221 during the transformation of the upstream burst Rx into the sequence of digital values.

Analog-to-digital converter 221 may receive a continuous-time linear equalizer (CTLE) signal from continuous-time linear equalizer 232. On such instances where analog-to-digital converter 221 transforms the upstream burst Rx into the sequence of digital values, analog-to-digital converter 221 may pre-condition the upstream burst Rx with the CTLE signal prior to transforming the upstream burst Rx into the sequence of digital values. While pre-conditioning the upstream burst Rx with the CTLE signal, analog-to-digital converter 221 may amplify higher-frequency components of the upstream burst Rx relative to lower frequencies to compensate for any high-frequency attenuation in the uplink.

Analog-to-digital converter 221 may sample the upstream burst Rx by measuring discrete amplitude levels of the upstream burst Rx at discrete sampling points. Referred to herein, a "sampling point" is the precise moment in time at which analog-to-digital converter 221 measures the discrete amplitude levels of the upstream burst Rx. Sampling points may occur at regular time intervals defined by the sampling rate.

Referred to herein, the "sampling rate" is the frequency at which analog-to-digital converter 221 measures discrete amplitude levels of the upstream burst Rx. The sampling rate, typically measured in samples per second (Hertz), dictates how frequently analog-to-digital converter 221 may measure the upstream burst Rx. For example, a 1 kHz sampling rate would mean that analog-to-digital converter 221 converter takes 1,000 samples of the upstream burst Rx per second. In other examples, a capture may be on the order of 1 megabits of data. Analog-to-digital converter 221 may adhere to the Nyquist criterion, which requires the sampling rate to be at least twice the maximum frequency of the upstream burst Rx to avoid aliasing. Control circuitry 234 may control the sampling rate of analog-to-digital converter 221.

Analog-to-digital converter 221 may receive a phase interpolation step signal from clock data recovery circuitry 221. On such instances where analog-to-digital converter 221 transforms the upstream burst Rx into a sequence of digital values, analog-to-digital converter 221 may process the phase interpolation step signal to dynamically select the sampling points to occur in more precise alignment with the phase of the upstream burst Rx. For example, during the upstream burst Rx, analog-to-digital converter 221 may select the sampling points that the phase interpolation step signal designates. In these situations, the phase interpolation step signal may designate sampling points that align more closely with characteristics of the upstream burst Rx such as peaks, troughs, zero-crossings and/or other distinguishing features of the upstream burst Rx. By designating the sampling points that align more closely with the characteristics of the upstream burst Rx, the phase interpolation step signal may cause analog-to-digital converter 221 to adjust the phase of time intervals at which the sampling points are to occur.

The sequence of digital values represents the discrete amplitude levels of upstream burst Rx measured by analog-to-digital converter 221 at the time intervals. Each digital value represents an amplitude level of the upstream burst Rx at a respective sampling point. Analog-to-digital converter 221 may quantize each amplitude level of the upstream burst Rx into a finite number of digital levels.

Typically expressed in bits (e.g., 4-bit, 9-bit, 16-bit, etc.), the term "resolution" referred to herein is the number of digital levels that analog-to-digital converter 221 may use to represent each amplitude level of the upstream burst Rx. In such instances, the resolution may be from 7 to 12 bits per sample at 50 giga samples per second. A higher resolution may provide finer granularity and greater precision in representing an amplitude level of the upstream burst Rx. For example, as a 5-bit converter, analog-to-digital converter 221 may have 32 possible levels of resolution. By comparison, analog-to-digital converter 221 as an 8-bit converter may have 256 possible levels of resolution, allowing for more detailed digital representation of the upstream burst Rx. The resolution examples are given merely for illustration and are not intended to limit the resolution of analog-to-digital converter 221. Instead, the resolution of analog-to-digital converter 221 may be any predetermined resolution.

Oversampling circuitry 222 may perform downsampling of the sequence. Referred to herein, "downsampling" is the process of selecting a subset of the digital values in the sequence. Oversampling circuitry 222 may receive, from control circuitry 234, a decimation factor that specifies how many of the digital values in the sequence are to be retained in the subset of the digital values. Each digital value retained in the subset is referred to herein as either a "decimated digital value," "decimated digital values" or "decimated ones of the digital values." Oversampling circuitry 222 may receive a position select signal from clock data recovery circuitry 221. Oversampling circuitry 222 may process the position select signal to select, for retention in the subset, the digital values identified by the position select signal as decimated digital values. Each digital value omitted from the subset is referred to herein as either a "discarded digital value," "discarded digital values" or "discarded ones of the digital values." As a result of selecting the decimated ones of the digital values, downsampling may reduce the processing load on the components of deserializer 132 that are subsequent to oversampling circuitry 222.

Feed-forward equalizer 223 is a digital filter that may compensate for intersymbol interference in the decimated digital values. Intersymbol interference is a type of signal distortion where overlapping symbols in the decimated digital values blur together due to factors that may degrade the upstream burst Rx. These factors may include, but are not limited to, signal attenuation, signal interference, distortion and noise. Such factors may impact the accuracy in the recovery of data from the upstream burst Rx.

Feed-forward equalizer 223 may include a sequential arrangement of taps. Each tap may delay the propagation of the decimated digital value through feed-forward equalizer 223 by a time step. Referred to herein, a "time step" is an increment of time between two taps. In some instances, the increment may equal the duration of any individual symbol in the upstream burst Rx. In other instances, the increment may be shorter than the duration of any individual symbol in the upstream burst Rx. Feed-forward equalizer 223 may process the decimated digital values in time steps.

Coefficient manager 235 may include coefficient database 245. Control circuitry 234 may, in response to transceiver 131 receiving the ranging request from ranging unit 110, query coefficient database 245 to ascertain a presence or absence in coefficient database 245 of a set of coefficients associated with ranging unit 110. As a noun, a "query" may be a structured request to obtain specific data or results from coefficient database 245. As a verb, "to query" may mean to perform the action of requesting information by sending a request to coefficient database 245.

In response to ascertaining the presence of the set of coefficients in coefficient database 245, control circuitry 234 may cause coefficient manager 235 assign the set of coefficients to the taps in feed-forward equalizer 223 during the ranging window.

Alternatively, in response to ascertaining the absence in coefficient database 245 of the set of coefficients for ranging unit 110, control circuitry 234 may cause coefficient manager 235 to create a default set of coefficients for ranging unit 110 and assign the default set to the taps in feed-forward equalizer 223 during the ranging window. The default set may include initial values of coefficients prior to a tuning of any coefficient for ranging unit 110. Tuning is a process where feed-forward equalizer 223 updates the weighting factor for any coefficient.

Control circuitry 234 may cause oversampling circuitry 222 to receive the sequence of digital values from analog-to-digital converter 221 during an active time slot. On other occasions, control circuitry 234 may cause oversampling circuitry 222 to receive the sequence of digital values from sequence memory 233. For instance, control circuitry 234 may cause sequence memory 233 to store the sequence of digital values from analog-to-digital converter 221 in response to a coefficient at a tap in feed-forward equalizer 223 being a default coefficient. Under such circumstances, control circuitry 234 may cause oversampling circuitry 222 to receive the sequence of digital values for unit 110 from sequence memory 233 during a time period other than an active time slot. For example, control circuitry 234 may cause oversampling circuitry 222 to receive the sequence of digital values from sequence memory 233 during moments of a ranging window where transceiver 131 receives no upstream burst Rx. Similarly, control circuitry 234 may cause oversampling circuitry 222 to receive the sequence of digital values from sequence memory 233 during an idle time slot. Causing oversampling circuitry 222 to receive the sequence of digital values for unit 110 from sequence memory 233 during a time period other than an active time slot may allow deserializer 132 to discover and receive serial data from units 110 having degraded upstream bursts Rx. Causing oversampling circuitry 222 to receive the sequence of digital values for unit 110 from sequence memory 233 during a time period other than an active time slot may reduce the time it takes for deserializer 132 to register a ranging unit 110.

To compensate for intersymbol interference, feed-forward equalizer 223 may propagate the decimated digital values through the taps. Coefficient manager 235 may assign a coefficient to each tap in feed-forward equalizer 223. A coefficient is a weighting factor. Feed-forward equalizer 223 may adjust the decimated digital value at each tap by an amount of the respective weighting factor. In many implementations, feed-forward equalizer 223 may repeatedly tune the coefficients for ranging unit 110 in real time throughout the entirety of the ranging window. Upon the completion of the ranging window, coefficient manager 235 may store the tuned coefficients for ranging unit 110 into coefficient database 245. As a result of tuning the decimated digital values, feed-forward equalizer 223 may convert the decimated digital values into a set of equalized digital values.

Clock data recovery circuitry 211 may monitor data bit transitions in the set of equalized digital values to obtain timing information for the upstream burst Rx. In response to obtaining timing information for the upstream burst Rx, clock data recovery circuitry 211 may generate the position select signal and the phase interpolation step signal. The phase interpolation step signal may designate sampling points that align more closely with characteristics of the upstream burst Rx such as peaks, troughs, zero-crossings and/or other distinguishing features of the upstream burst Rx. The position select signal may identify an optimal position for oversampling circuitry 222 to sample the center of each data bit in the sequence of digital values.

Decision feedback equalizer 224 is an equalizer that may compensate for intersymbol interference in the equalized digital values. Intersymbol interference is a type of signal distortion where overlapping symbols in the equalized digital values blur together due to factors that may degrade the upstream burst Rx. Decision feedback equalizer 224 may include a feedforward filter that corrects linear distortions in an equalized digital value and a feedback filter that subtracts intersymbol interference from the corrected equalized digital value.

Packing circuitry 225 may convert a stream of the corrected equalized digital values from decision feedback equalizer 224 into parallel data of an original parallel format. Referred to herein, an "original parallel format" is parallel structured arrangement of data in the upstream burst Rx prior to conversion for serialization by unit 110.

Gearbox 236 may adjust the data width of the parallel data from packing circuitry 225 between different clock domains or interface requirements without altering the overall data throughput. For example, an instruction from control circuitry 234 may cause gearbox 236 to convert the parallel data from an 8-bit structure at clock rate to a 16-bit structure at half the clock rate as the 8-bit structure.

Those skilled in the art will also appreciate the arrangement or interconnection of components such as "coupled," "connected," "on," "under," or similar wording allows for indirect connections, or intervening components or layers.

Certain operations of methods according to the technology, or of systems executing those methods, may be represented schematically in the figures or otherwise discussed herein. Unless otherwise specified or limited, representation in the figures of particular operations in particular spatial order may not necessarily require those operations to be executed in a particular sequence corresponding to the particular spatial order. Correspondingly, certain operations represented in the figures, or otherwise disclosed herein, may be executed in different orders than are expressly illustrated or described, as appropriate for particular examples of the technology. Further, in some examples, certain operations may be executed in parallel or partially in parallel, including by dedicated parallel processing devices, or separate computing devices configured to interoperate as part of a large system.

As used herein, unless otherwise limited or defined, "or" indicates a non-exclusive list of components or operations that may be present in any variety of combinations, rather than an exclusive list of components that may be present only as alternatives to each other. For example, a list of "A, B, or C" indicates options of: A; B; C; A and B; A and C; B and C; and A, B, and C.

Correspondingly, the term "or" as used herein is intended to indicate exclusive alternatives only when preceded by terms of exclusivity, such as, e.g., "either," "only one of," or "exactly one of." Further, a list preceded by "one or more" (and variations thereon) and including "or" to separate listed elements indicates options of one or more of any or all of the listed elements.

For example, the phrases "one or more of A, B, or C" and "at least one of A, B, or C" indicate options of: one or more A; one or more B; one or more C; one or more A and one or more B; one or more B and one or more C; one or more A and one or more C; and one or more of each of A, B, and C.

Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

In general, the term "or" as used herein only indicates exclusive alternatives (e.g., "one or the other but not both") when preceded by terms of exclusivity, such as, e.g., "either," "only one of," or "exactly one of."

Any mark, if referenced herein, may be common law or registered trademarks of third parties affiliated or unaffiliated with the applicant or the assignee. Use of these marks is by way of example and shall not be construed as descriptive or to limit the scope of disclosed or claimed embodiments to material associated only with such marks.

The articles "a," "an," and "the" are intended to include the plural forms as well, unless the context clearly indicates otherwise.

The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Throughout the application, ordinal numbers (e.g., first, second, third, etc.) may be used as an adjective for an element (i.e., any noun in the application).

Although terms such as "first," "second," and "third" may be used herein to describe various members, components, regions, layers, or sections, these members, components, regions, layers, or sections are not to be limited by these terms.

Rather, these terms are only used to distinguish one member, component, region, layer, or section from another member, component, region, layer, or section.

The use of ordinal numbers is not to imply or create any particular ordering of the elements nor to limit any element to being only a single element unless expressly disclosed, such as by the use of the terms "before," "after," "single," and other such terminology.

Rather, the use of ordinal numbers is to distinguish between the elements.

By way of an example, a first element is distinct from a second element, and the first element may encompass more than one element and succeed (or precede) the second element in an ordering of elements.

Thus, a first member, component, region, layer, or section referred to in examples described herein may also be referred to as a second member, component, region, layer, or section without departing from the teachings of the examples.

The following are further embodiments of the invention:
1. An apparatus comprising:
   a transceiver configured to:
      receive a stream of bursts from a plurality of units, one of the units being an electronic device;
   an analog-to-digital converter configured to:
      receive an upstream burst from the transceiver during an active time slot, the upstream burst being one of the bursts, and
      convert, in response to sampling the upstream burst at a sample rate, the upstream burst from an analog waveform into a sequence of digital values; and
   control circuitry configured to:
      store, in response to a coefficient for the electronic device being a default coefficient, the digital values into memory during the active time slot.
2. The apparatus according to embodiment 1, wherein the active time slot is a time period where the transceiver receives any one of the bursts in the stream.
3. The apparatus according to embodiment 1, wherein the transceiver is configured to receive the stream of bursts in real time.
4. The apparatus according to embodiment 1, wherein the upstream burst comprises multiple packets of information.
5. The apparatus according to embodiment 1, wherein the sequence is a digital representation of the analog waveform.
6. The apparatus according to embodiment 1, wherein the control circuitry is configured to retrieve, during an idle time slot, the sequence in the memory.
7. The apparatus according to embodiment 4, wherein the idle time slot is a time period between the active time slot and another active time slot.
8. The apparatus according to embodiment 4, further comprising:
   oversampling circuitry configured to perform a downsampling of the sequence.
9. The apparatus according to embodiment 5, wherein the oversampling circuitry is configured to omit, from the sequence in response to the downsampling, discarded ones of the digital values.
10. The apparatus according to embodiment 5, wherein the oversampling circuitry is configured to retain, in the sequence as a result of the downsampling, decimated ones of the digital values.
11. The apparatus according to embodiment 6, wherein the oversampling circuitry is configured to process, to retain the decimated ones of the digital values, a position select signal that identifies the decimated ones of the digital values in the sequence.
12. The apparatus according to embodiment 5, wherein the control circuitry is configured to cause, during the active time slot, the oversampling circuitry to receive the sequence from the analog-to-digital converter.
13. The apparatus according to embodiment 5, wherein the control circuitry is configured to cause, during the idle time slot, the oversampling circuitry to receive the sequence in the memory.
14. The apparatus according to embodiment 8, wherein the idle time slot is a time period where the transceiver is awaiting one or more of the bursts.
15. The apparatus according to embodiment 9, wherein the transceiver is configured to receive the stream of bursts from a transmission path.
16. The apparatus according to embodiment 4, further comprising:
   an equalizer configured to:
   cause, in response to processing the sequence during the idle time slot, the coefficient to become a learned coefficient.
17. The apparatus according to embodiment 11, wherein the equalizer is a feed-forward equalizer.
18. A method comprising:
   receiving, by a transceiver, a stream of bursts from a plurality of units;
   receiving, by an analog-to-digital converter, an upstream burst from the transceiver during an active time slot;
   sampling, by an analog-to-digital converter, the upstream burst at a sample rate;
   converting, by the analog-to-digital converter in response to sampling the upstream burst, the upstream burst from an analog waveform into a sequence of digital values; and
   storing, by control circuitry in response to a coefficient for an electronic device being a default coefficient, the digital values into memory during the active time slot,
   wherein one of the units is the electronic device, and
   wherein the upstream burst is one of the bursts.
19. A network comprising:
   a terminal comprising a transceiver, an analog-to-digital converter and control circuitry,
   wherein:
      the transceiver is configured to receive, during an active time slot, a burst of information from an electronic device,
      the analog-to-digital converter is configured to convert, in response to sampling the burst at a sample rate, the burst from an analog waveform into a sequence of digital values; and
      the control circuitry is configured to store, in response to a coefficient for the electronic device being a default coefficient, the digital values into memory during the active time slot.
20. The network according to embodiment 14, wherein the burst comprises multiple packets of the information.

## Claims

1. An apparatus comprising:
a transceiver configured to:
receive a stream of bursts from a plurality of units, one of the units being an electronic device;
an analog-to-digital converter configured to:
receive an upstream burst from the transceiver during an active time slot, the upstream burst being one of the bursts, and
convert, in response to sampling the upstream burst at a sample rate, the upstream burst from an analog waveform into a sequence of digital values; and
control circuitry configured to:
store, in response to a coefficient for the electronic device being a default coefficient, the digital values into memory during the active time slot.

2. The apparatus according to claim 1, wherein the active time slot is a time period where the transceiver receives any one of the bursts in the stream,
and/or
wherein the transceiver is configured to receive the stream of bursts in real time.

3. The apparatus according to claim 1 or 2, wherein the upstream burst comprises multiple packets of information,
and/or
wherein the sequence is a digital representation of the analog waveform.

4. The apparatus according to one of the previous claims, wherein the control circuitry is configured to retrieve, during an idle time slot, the sequence in the memory,
in particular,
wherein the idle time slot is a time period between the active time slot and another active time slot.

5. The apparatus according to claim 4, further comprising:
oversampling circuitry configured to perform a downsampling of the sequence,
in particular,
wherein the oversampling circuitry is configured to omit, from the sequence in response to the downsampling, discarded ones of the digital values.

6. The apparatus according to claim 5, wherein the oversampling circuitry is configured to retain, in the sequence as a result of the downsampling, decimated ones of the digital values,
in particular,
wherein the oversampling circuitry is configured to process, to retain the decimated ones of the digital values, a position select signal that identifies the decimated ones of the digital values in the sequence.

7. The apparatus according to claim 5, wherein the control circuitry is configured to cause, during the active time slot, the oversampling circuitry to receive the sequence from the analog-to-digital converter.

8. The apparatus according to claim 5, wherein the control circuitry is configured to cause, during the idle time slot, the oversampling circuitry to receive the sequence in the memory.

9. The apparatus according to claim 8, wherein the idle time slot is a time period where the transceiver is awaiting one or more of the bursts.

10. The apparatus according to claim 9, wherein the transceiver is configured to receive the stream of bursts from a transmission path.

11. The apparatus according to claim 4, further comprising:
an equalizer configured to:
cause, in response to processing the sequence during the idle time slot, the coefficient to become a learned coefficient.

12. The apparatus according to claim 11, wherein the equalizer is a feed-forward equalizer.

13. A method comprising:
receiving, by a transceiver, a stream of bursts from a plurality of units;
receiving, by an analog-to-digital converter, an upstream burst from the transceiver during an active time slot;
sampling, by an analog-to-digital converter, the upstream burst at a sample rate;
converting, by the analog-to-digital converter in response to sampling the upstream burst, the upstream burst from an analog waveform into a sequence of digital values; and
storing, by control circuitry in response to a coefficient for an electronic device being a default coefficient, the digital values into memory during the active time slot,
wherein one of the units is the electronic device, and
wherein the upstream burst is one of the bursts.

14. A network comprising:
a terminal comprising a transceiver, an analog-to-digital converter and control circuitry,
wherein:
the transceiver is configured to receive, during an active time slot, a burst of information from an electronic device,
the analog-to-digital converter is configured to convert, in response to sampling the burst at a sample rate, the burst from an analog waveform into a sequence of digital values; and
the control circuitry is configured to store, in response to a coefficient for the electronic device being a default coefficient, the digital values into memory during the active time slot.

15. The network according to claim 14, wherein the burst comprises multiple packets of the information.
